(19) Europäisches Patentamt
European Patent Office
Office européen des brevets

(11) **EP 1 696 563 A1**

(12) **EUROPEAN PATENT APPLICATION**
published in accordance with Art. 158(3) EPC

(43) Date of publication:
**30.08.2006 Bulletin 2006/35**

(51) Int Cl.:
*H03H 17/06* (2006.01)

(21) Application number: **04747948.0**

(22) Date of filing: **20.07.2004**

(86) International application number:
**PCT/JP2004/010585**

(87) International publication number:
**WO 2005/057784 (23.06.2005 Gazette 2005/25)**

(84) Designated Contracting States:
**DE FR GB**

(30) Priority: **12.12.2003 JP 2003415517**

(71) Applicant: **Neuro Solution Corp.**
**Tokyo 158-0091 (JP)**

(72) Inventor: **Koyanagi, Yukio**
**Saitama-shi,**
**Saitama 3360932 (JP)**

(74) Representative: **Vossius & Partner**
**Siebertstrasse 4**
**81675 München (DE)**

(54) **DIGITAL FILTER DESIGNING METHOD AND DESIGNING DEVICE**

(57) A digital filter having the desired frequency characteristic can be designed through an extremely simple processing, which comprises: generating a plurality of filters, by a frequency shift calculation to a basic filter having a passband width equal to a sampling frequency divided by an integer, from the frequency/amplitude characteristic of the basic filter being shifted by a prescribed frequency so that the adjacent filter banks are overlapped each other at the part of one-half amplitude; and obtaining the final filter coefficients by arbitrarily selecting one or more filters among the basic filter and a plurality of frequency-shifted filters and adding the final filter coefficients thereof.

F I G. 1

START

GENERATE BASIC FILTER — S1

GENERATE FREQUENCY-SHIFTED FILTER — S2

SELECT DESIRED FILTERS AND ADD FILTER COEFFICIENTS THEREOF — S3

END

**Description**

[Field of the Invention]

The present invention relates to a digital filter designing method and a designing device, specifically to a designing method of an FIR filter.

[Description of the Related Art]

As one form of digital filters, there is a finite impulse response (FIR) filter. The FIR filter having a tapped delay line which comprises a plurality of delay devices is one type of filters which multiplies output signals of each tap several-fold using the filter coefficients and adds up the multiplied results to be outputted. There are two advantages in such FIR filter. Firstly, a circuit is constantly stable because the pole of transfer function of the FIR filter exists only at an origin point on Z plane. Secondary, linearly phase characteristics with complete accuracy can be achieved if the filter coefficients are symmetric.

In the FIR filter, an impulse response represented by finite time length itself constitutes filter coefficients as are. Therefore, designing the FIR filter is equal to determine the filter coefficients so that the desired frequency characteristic is obtained. As conventional steps of designing an FIR filter, filter coefficients are calculated based on a targeted frequency characteristic, followed by a window function processing to obtain the finite number of coefficient group. Then, the obtained coefficient group is subjected to a fast Fourier transform (FFT) to be converted to the frequency characteristic and it is checked whether the characteristic satisfies the targeted values or not.

When the filter coefficients are calculated from the targeted frequency characteristic, for example, a convolution calculation using Chebyshev approximation or the like is performed based on a ratio between a sampling frequency and a cutoff frequency. However, since the frequency characteristic of the FIR filter obtained by a conventional designing method is in dependence on a window function and an approximation formula, the preferable targeted frequency characteristic cannot be obtained unless the window function and the approximation formula are appropriately set. However, it is generally difficult to set the appropriate window function and approximation formula. Moreover, the window function processing causes the discretization error of coefficients. For these reasons, it is extremely difficult to attain the desired frequency characteristic.

A method for adjusting a filter bank band by inserting one or more zero values each between taps (filter coefficients) of a tapped delay line has been known (see Patent Document 1, for example). Besides, a method for realizing precipitous frequency characteristic using a plurality of FIR filters being cascade-connected has been known (see Patent Document 2, for example). However, even using one of these methods can only narrow the passband of the filter, and cannot realize the precise frequency characteristic of an arbitrary shape.

Patent Document 1: Japanese Publication of PCT Application No. H6-503450
Patent Document 2: Japanese Patent Application Laid-open No. H5-243908

[Summary of the Invention]

The present invention has been implemented to solve these problems and it is an object of the present invention to design a digital filter required precise frequency characteristic in an arbitrary shape through a simple processing.

In order to solve the above-mentioned problems, a digital filter designing method of the present invention comprises a first step of generating a plurality of frequency-shifted filters, through a frequency shift calculation to a basic filter which realizes frequency/amplitude characteristic having a passband width determined by dividing a sampling frequency by an integer, which realizes the frequency/amplitude characteristics obtained from the frequency/amplitude characteristics of the basic filter being shifted by a prescribed frequency so that the adjacent filter banks are overlapped each other at the part of one-half amplitude and a second step of obtaining filter coefficients of the digital filter as a final product by summing the filter coefficients of one or more arbitrary filters extracted among a plurality of filters including the basic filter and the frequency-shifted filters.

Furthermore, a digital filter designing device of the present invention comprises a coefficient table storage means for storing a table data of filter coefficient group including filter coefficients of a basic filter which realizes frequency/amplitude characteristic having a passband width determined by dividing a sampling frequency by an integer and filter coefficients of a plurality of frequency-shifted filters which realizes the frequency/amplitude characteristics obtained from the frequency/amplitude characteristics of the basic filter being shifted by a prescribed frequency so that the adjacent filter banks are overlapped each other at the part of one-half amplitude and a calculation means for obtaining filter coefficients of the digital filter as a final product by summing filter coefficients of one or more filters designated among the filter coefficient group stored in the coefficient table storage means.

According to the present invention comprising the above-mentioned configuration, an FIR digital filter having frequency/amplitude characteristic in an arbitrary shape can be precisely designed through an extremely simple processing of summing the filter coefficients of one or more desired filters selected from a basic filter and a plurality of frequency-shifted filters generated from the basic filter.

[Brief Description of the Drawings]

Fig. 1 is a flowchart showing steps of a designing method of an FIR digital filter according to the present embodiment.
Fig. 2 is a flowchart showing steps of a producing method of a basic filter according to the present embodiment.
Fig. 3 is a diagram showing frequency/amplitude characteristic of a basic filter.
Fig. 4 is a diagram showing frequency/amplitude characteristics of a basic filter and a plurality of frequency-shifted filters produced from the basic filter.
Fig. 5 is a diagram showing an example of frequency/amplitude characteristic of a digital filter produced with a filter designing method of the present embodiment.
Fig. 6 is a diagram showing frequency/amplitude characteristics of a basic unit filter and a filter produced by inserting an integer of "0" between each filter coefficient of the basic unit filter.
Fig. 7 is a diagram of frequency/amplitude characteristic for explaining cutout of a basic filter by a window filter.
Fig. 8 is a diagram for explaining the specific calculation for determining filter coefficients of a basic filter.
Fig. 9 is a block diagram showing a designing device of an FIR digital filter according to the present embodiment.

[Detailed Description of the Preferred Embodiments]

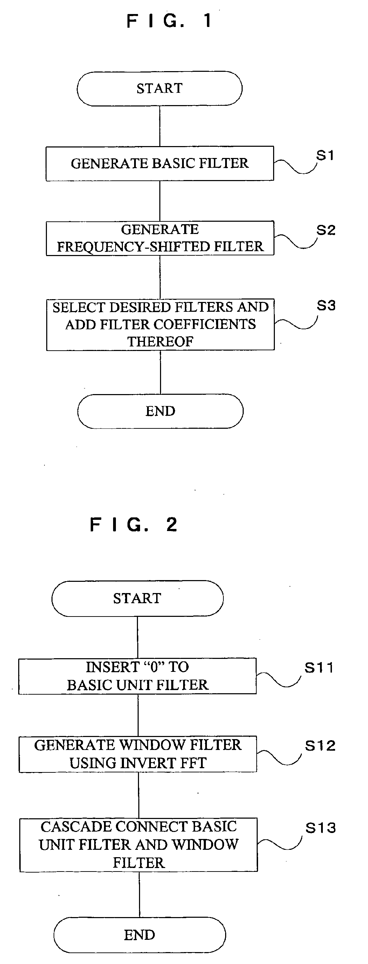

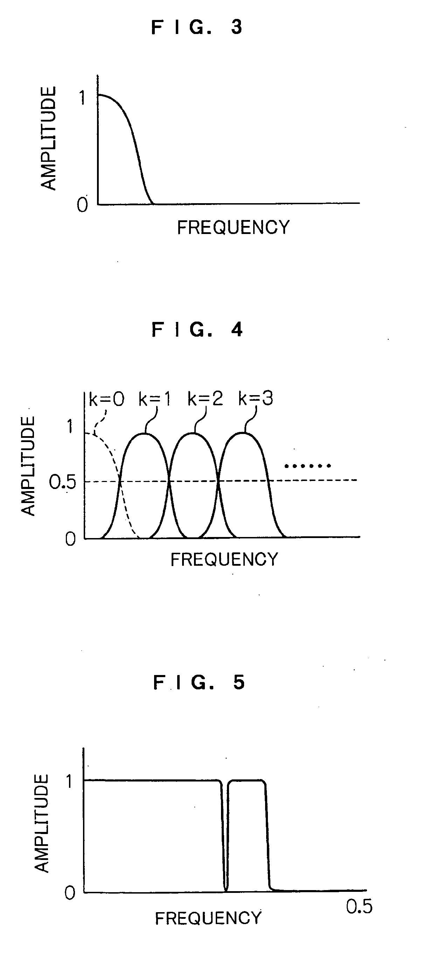

One embodiment of the present invention will be explained below referring to drawings. Fig. 1 and Fig. 2 are flow charts showing steps of a designing method of an FIR digital filter according to the present embodiment. Fig. 3 to Fig. 7 are diagrams of frequency characteristics for explaining concepts of a designing method of an FIR digital filter according to the present embodiment. Regarding the frequency/amplitude characteristics in Fig. 3 to Fig. 7, the frequency axis and amplitude axis are individually normalized to "1".

Fig. 1 is a flowchart showing an overall process flow of the designing method of the FIR digital filter according to the present embodiment. First of all, in Fig. 1, a basic filter wherein the numeric sequence of filter coefficients is symmetric is produced (step S1). This basic filter has frequency/amplitude characteristic having a passband width determined by multiplying by $1/n$ (n is an integer of one or more) a sampling frequency $f_s$ of a signal to be filtered. Fig. 3 indicates frequency/amplitude characteristic of a basic filter. Specifically, Fig. 3 indicates frequency/amplitude characteristic of the basic filter having a bandwidth determined by dividing a half sampling frequency $f_s$ equally into 128.

Then, by performing a frequency shift calculation for the basic filter having frequency/amplitude characteristic as shown in Fig. 3, a plurality of frequency-shifted filters wherein frequency/amplitude characteristics of the basic filter are shifted by every prescribed frequency so that adjacent filter banks are overlapped each other in the part of one half amplitude is produced (step S2). The frequency shift is performed with calculation mentioned below.

Providing that a filter coefficient sequence of the basic filter is $\{H_{-i}{}^0, H_{-(i-1)}{}^0, H_{-(i-2)}{}^0, ..., H_{-1}{}^0, H_0{}^0, H_1{}^0, ..., H_{i-2}{}^0, H_{i-1}{}^0, H_i{}^0\}$ (which is a symmetric type with a coefficient of $H_0{}^0$ as a center) and a filter coefficient sequence of $k^{th}$ frequency-shifted filter counted from the basic filter (obtained from the frequency/amplitude characteristic of the basic filter being frequency shifted by "a prescribed frequency $\times$ k") is $\{H_{-i}{}^k, H_{-(i-1)}{}^k, H_{-(i-2)}{}^k, ..., H_{-1}{}^k, H_0{}^k, H_1{}^k, ..., H_{i-2}{}^k, H_{i-1}{}^k, H_i{}^k\}$, the coefficient $H_j{}^k$ with a coefficient number of j (j = -i, -(i-1), -(i-2), ..., -1, 0, 1, ..., i-2, i-1, i) in the $k^{th}$ frequency-shifted filter is determined by using the following formula:

$$H_j{}^k = H_j{}^0 \times 2\cos\left(2\pi k j / (n/2)\right)$$

For example, the coefficient $H_{-i}{}^k$ with a coefficient number of -i in the $k^{th}$ frequency-shifted filter is determined by using the following formula:

$$H_{-i}{}^k = H_{-i}{}^0 \times 2\cos\left(2\pi k \times (-i) / (n/2)\right)$$

Also, the coefficient $H_{-(i-1)}{}^k$ with a coefficient number of -(i-1) is determined by using the following formula:

$$H_{-(i-1)}{}^{k} = H_{-(i-1)}{}^{0} \times 2\cos\left(2\pi k \times (-(i-1)) / (n/2)\right)$$

The other coefficients $\{H_{-(i-2)}{}^{k}, ..., H_{-1}{}^{k}, H_0{}^{k}, H_1{}^{k}, ..., H_{i-2}{}^{k}, H_{i-1}{}^{k}, H_i{}^{k}\}$ are also determined through the same calculation.

Fig. 4 shows frequency/amplitude characteristics of a plurality of frequency-shifted filters produced by the step S2 (a dotted line indicates frequency/amplitude characteristic of the basic filter). Through the process of the above steps S1 and S2, the filter coefficient group of a plurality of filters having frequency/amplitude characteristics which allows adjacent filter banks to overlap each other at the part of one-half amplitude is obtained. Although the number of filters produced by the frequency shift is arbitrary, for example, the total number of the basic filter and frequency-shifted filters is 128 when the bandwidth of the basic filter is determined by dividing a half sampling frequency $f_s$ into 128. The frequency range defined by the number of produced filters is the designing area of the digital filter as a final production.

By extracting one or more arbitrary filters from a plurality of filters produced by the above steps S1 and S2 and summing correspondent filter coefficients thereof in each coefficient number, the final filter coefficients are obtained (step S3). For example, when $k$th frequency-shifted filter and $(k + 1)$th frequency-shifted filter counted from the basic filter are added together, the targeted filter coefficients are determined as follows:

$\{H_{-i}{}^{k} + H_{-i}{}^{k+1}, H_{-(i-1)}{}^{k} + H_{-(i-1)}{}^{k+1}, H_{-(i-2)}{}^{k} + H_{-(i-2)}{}^{k+1}, ..., H_{-1}{}^{k} + H_{-1}{}^{k+1}, H_0{}^{k} + H_0{}^{k+1}, H_1{}^{k} + H_1{}^{k+1}, ..., H_{i-2}{}^{k} + H_{i-2}{}^{k+1}, H_{i-1}{}^{k} + H_{i-1}{}^{k+1}, H_i{}^{k} + H_i{}^{k+1}\}$

Fig. 5 is a diagram showing one example of frequency/amplitude characteristic owned by the digital filter finally produced in the step S3. A scale of the frequency axis in Fig. 5 is dramatically compressed in compared with Fig. 3 and Fig. 4. The frequency/amplitude characteristic shown in Fig. 5 are possessed by the digital filter produced by extracting a plurality of filters corresponding to k=0-31 and k=33-38 and summing correspondent filter coefficients thereof in each coefficient number.

Since adjacent filters are produced so that filter banks are overlapped precisely in the part of one-half amplitude, the amplitude becomes exactly "1" when the filter coefficients thereof are added together. As a result, the top of a passband of the resulting filter is flatted. Therefore, when 32 filter coefficients corresponding to k=0-31 are added together, each top of the 32 filters is flatted, and a passband with a bandwidth of $(f_s2/128) \times 32$ is obtained. As a filter corresponding to k=32 is not a target to be added together, a trap is occurred in its part. Moreover, when the coefficients of six filters corresponding to k=33-38 are added together, each top of the six filters is flatted, and a passband having a bandwidth of $(f_s/2/128) \times 6$ is obtained. Thus, a low pass filter in a particular form having the passband in the part of k=0-38 and the trap in the part of k=32 can be obtained.

The producing method of the basic filter in the above step S1 will be explained in details. In the present invention, there is no particular limitation to the producing method of the basic filter and various producing methods are applicable. Fig. 2 is a flowchart showing one example of the producing process of the basic filter. First of all, in Fig. 2, filter banks are adjusted by inserting a plurality of "0" between numeric values which constitute a basic numeric sequence in a symmetric type owned by a basic unit filter (step S11).

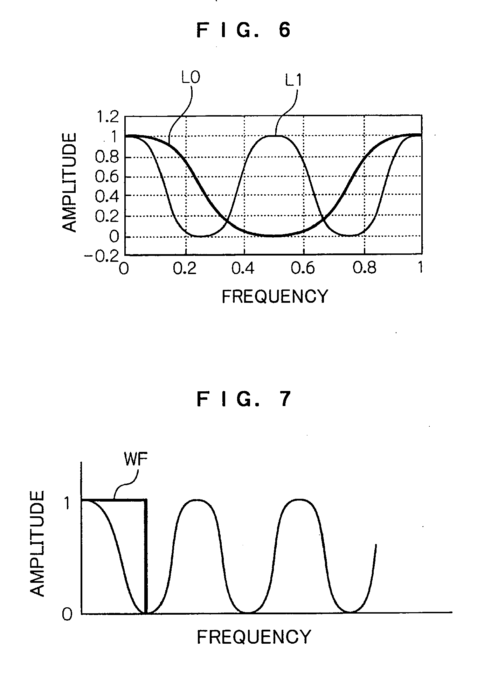

Fig. 6 is a diagram showing frequency/amplitude characteristics when a basic unit filter has a numeric sequence of filter coefficients {-1, 0, 9, 16, 9, 0, -1} (hereinafter the basic unit filter is referred to as "L0") and when a filter has a numeric sequence wherein one integer of "0" is inserted at a time between the numeric sequence (hereinafter the filter in this instance is referred to as "L1").

As shown in Fig. 6, the basic unit filter L0 with filter coefficients comprising the numeric sequence {-1, 0, 9, 16, 9, 0, -1} accomplishes low pass filter characteristic having one passband both sides a center frequency. When one integer of "0" is inserted at a time between each filter coefficient of such basic unit filter L0, a frequency axis of the frequency/amplitude characteristic (a cycle to the frequency direction) becomes one half (1/2) and the number of passbands increases. Likewise, when the number of "0" to be inserted between the filter coefficients is (n+1), the frequency axis of the frequency/amplitude characteristic becomes 1/n.

Therefore, when the number of "0" to be inserted is 127, frequency/amplitude characteristic of a low pass filter having passbands each with a bandwidth determined by dividing a half sampling frequency $f_s$ into 128 is obtained. However, as the frequency characteristic is a continuous wave wherein 128 passbands exist in the band lower than the center frequency, the frequency characteristic of a single wave constituting the basic filter such as in Fig. 3 needs to be cutout from the continuous wave. The cutout is performed with the process in steps S12 and S13 mentioned below.

For performing the cutout of a single wave, a window filter WF as shown in Fig. 7 is produced at first (step S12). The window filter WF has a passband which is a common to that of the single wave to be extracted as the basic filter as shown in Fig. 3. By cascade connecting such window filter WF with the basic unit filter L127, the basic filter as shown in Fig. 3 is extracted (step S13).

In the present invention, the producing method of the window filter WF is not particularly limited and a variety of producing methods is applicable. As one example, there is a method comprising steps of inputting a plurality of amplitude values expressing frequency characteristic of a window filter WF and of performing inverse Fourier transform to the inputted numeric sequence. As well known, by performing fast Fourier transform (FFT) to a numeric sequence, a waveform of frequency/amplitude characteristic corresponding to the numeric sequence can be obtained. Therefore, an original numeric sequence required to attain the desired frequency/amplitude characteristic can be obtained by inputting a numeric sequence expressing a waveform of the desired frequency/amplitude characteristic, performing inverse FFT to the inputted numeric sequence, and extracting the real number thereof. This numeric sequence is equivalent of filter coefficients of the targeted window filter WF.

Fundamentally, the infinite number of filter coefficients as well as the infinite number of filter taps is required to constitute an ideal filter. Therefore, it is preferable to increase the number of input data corresponding to the number of filter coefficients to the degree that a frequency error to the desired frequency is within the required range in order to decrease the error. However, regarding the window filter WF, only the whole passband of the basic filter is required to be included in the passband and no more precision is demanded. Therefore, the number of input data of a numeric sequence (the number of filter coefficients of a window filter WF) need not be increased so much. The number of filter coefficients can be further reduced by additional window function processing and the like to the filter coefficients obtained by the inverse FFT calculation.

In the input of amplitude values which expresses frequency characteristic of the window filter WF, numeric values at individual sample points may be inputted directly or after drawing a waveform of the desired frequency characteristic in a two dimensional input coordinate for indicating the frequency/amplitude characteristic, the numeric values of the numeric sequence replaced from the drawn waveform may be inputted. By using the latter input method, the input of the data indicating the desired frequency characteristic can be easily performed through intuition while verifying the desired frequency characteristic as an image.

There are some possible ways for accomplishing the latter input method. For example, there is a method comprising steps of displaying a two dimensional plane indicating frequency/amplitude characteristic on a display screen of a computer, drawing a waveform of the desired frequency characteristic on the two dimensional plane by a graphical user interface (GUI) and the like, and converting the drawn waveform into the numeric data. A pointing device such as a digitizer or plotter may be used instead of the GUI on the computer screen. The method explained here is an example and the other method may be used for inputting the numeric sequence. Besides, the desired frequency/amplitude characteristic is inputted as the numeric sequence in the example, the characteristics may be inputted as a function representing a waveform of the characteristic.

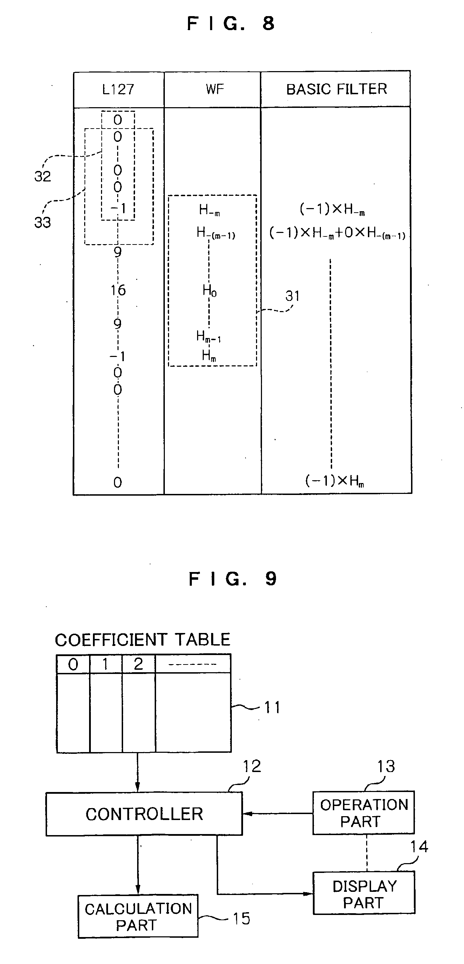

The cascade connection of the filter in the step S13 can be performed by calculation of the filter coefficients as mentioned below. Fig. 8 is a diagram for explaining the specific calculation in the step S13. As shown in Fig. 8, in the step S13, a numeric sequence of filter coefficients of the basic filter is obtained by a convolution calculation of $(2m+1)$ sequential numeric values constituting the filter coefficients of the basic unit filter L127 and $(2m+1)$ sequential numeric values constituting the filter coefficients of the window filter WF.

For the filter coefficients of the window filter WF in the convolution calculation, all the sequential numeric values $\{H_{-m}, H_{-(m-1)}, ..., H_{-1}, H_0, H_1, ..., H_{m-1}, H_m\}$ are the fixed target of multiplication and addition. On the other hand, for the filter coefficients of the basic unit filter L127, zero values are assumed to exist before and after the numeric sequence $\{-1, 0, ..., 9, 0, ..., 16, 0, ..., 9, 0, ..., -1\}$ and $(2m+1)$ sequential numeric values including the zero values are the target of the convolution calculation.

When $x^{th}$ numeric value is determined in filter coefficients of the basic filter, the target of multiplication and addition is $(2m+1)$ sequential numeric values comprising $x^{th}$ numeric value and numeric values preceding the same in the filter coefficients of the basic unit filter L127. For example, when first numeric value in the filter coefficients of the basic filter is determined, the numeric sequence of all the filter coefficients of the window filter WF $\{H_{-m}, H_{-(m-1)}, ..., H_{-1}, H_0, H_1, ..., H_{m-1}, H_m\}$ (the sequence circled with the dotted line represented by 31) and $(2m+1)$ sequential numeric values including the first numeric value of the filter coefficients of the basic unit filter L127 and numeric values preceding the first numeric value $\{0, 0, ..., 0, -1\}$ (the numeric sequence circled with the dotted line represented by 32) are the target and the calculation is performed to determine the total of the multiplied elements corresponding in the sequence. The result of this calculation becomes $((-1) \times H_{-m})$.

When the second numeric value in the filter coefficients of the basic filter is determined, the numeric sequence of all the filter coefficients of the window filter WF $\{H_{-m}, H_{-(m-1)}, ..., H_{-1}, H_0, ..., H_{m-1}, H_m\}$ (the sequence circled with the dotted line represented by 31) and $(2m+1)$ sequential numeric values including second numeric value of the filter coefficients of the basic unit filter L127 and numeric values preceding the second numeric value $\{0, 0, ..., 0, -1, 0\}$ (the sequence circled with the dotted line represented by 33) are the target and the calculation is performed to determined the total of the multiplied elements corresponding in the sequence. In this instance, the result of this calculation is $((-1) \times H_{-m} + 0 \times H_{-(m-1)})$. The $(2 \times (2m+1)-1)$ sequential numeric values constituting the filter coefficients of the basic filter are determined in the same way.

By inputting the amplitude values expressing the frequency characteristic of the basic filter and performing invert FFT, the filter coefficients of the basic filter can be directly determined. However, in order to constitute an ideal basic filter with invert FFT (to decrease the error with the desired frequency characteristic), the number of input data corresponding to the filter coefficients need to be extremely increased. This result in the enormous number of filter coefficients constituting the basic filter as well as the enormous number of filter coefficients as the final product produced utilizing the filter coefficients constituting the basic filter. Therefore, if the number of filter coefficients is desired to be decreased as small as possible, it is preferable to produce the basic filter using the window filter WF as mentioned above.

After determining the filter coefficients of the basic filter, filter coefficients of a plurality of frequency-shifted filters are further determined with the frequency shift calculation. Then, one or more arbitrary filters are extracted from the basic filter and a plurality of frequency-shifted filters and the filter coefficients thereof are added together in each corresponding coefficient number to determine the final filter coefficients. By arbitrary changing the filters to be extracted, a digital filter having arbitrary frequency characteristic can be produced.

Although an example for producing the low pass filter partly having the trap is shown in Fig. 5, the other filter having a passband in the arbitrary frequency band such as a low pass filter, high pass filter, band pass filter, and band elimination filter can be produced. Moreover, a comb-type filter and the other digital filter having particular frequency characteristic can be produced through a simple processing. If a divisional number (number of n) is large when producing the basic filter, the inclination in the blocking bandwidth of the basic filter and each frequency-shifted filter increases while the resolution to the filter designing area becomes higher, thereby a digital filter precisely conforming to the desired frequency characteristic can be produced.

Fig. 9 is a block diagram showing a configuration example of a digital filter designing device of the present embodiment. In Fig. 9, 11 indicates a filter coefficient table wherein the table data of the filter coefficient group including the filter coefficients of the above-mentioned basic filter and the filter coefficients of a plurality of frequency-shifted filters (the filter coefficient group of all the frequency band constituting the filter designing area) is stored. The numbers in the lateral axis indicate serial numbers of filters. In other words, the filter coefficients of the basic filter are stored in the row with a serial number of zero and the filter coefficients of frequency-shifted filters are stored in the rows with a serial number of one and after. 12 is a controller to control the whole device.

13 is an operation part for selecting one or more arbitrary filters from the basic filter and a plurality of frequency-shifted filters. The operation part 13 comprises, for example, input devices such as a key board or a mouse. 14 is a display part to display a selection screen when one or more arbitrary filters are selected. In the selection screen, the row numbers of the filter coefficient table 11 may be displayed to be selected, or a waveform of the frequency characteristics such as in Fig. 4 may be displayed to be selected.

15 is a calculation part to determine the filter coefficients of the FIR digital filter through an addition, in each corresponding coefficient number, of the filter coefficients (read out from the filter coefficient table 11 by the controller 12) of filters selected from the basic filter and a plurality of frequency-shifted filters by the operation part 13. In the digital filter designing device of the present embodiment, the filter coefficients of the basic filter and a plurality of frequency-shifted filters are obtained and converted into the table data in advance. Thus, the desired digital filter can be designed through an extremely simple calculation which is the addition of the filter coefficients of the filters selected by the user's operation of the operation part 13.

As mentioned above in details, according to the present embodiment, an FIR digital filter required precise frequency characteristic can be designed with an extremely simple way.

Although the example using {-1, 0, 9, 16, 9, 0, -1} as a numeric sequence of filter coefficients of the basic unit filter is explained in the above embodiment, it is not construed as limiting the present invention. Any numeric sequence in a symmetric type is applicable in the present invention.

Besides, in the above embodiment, although the example wherein the low pass filter used as the basic filter is frequency shifted to the high frequency side is explained, it is not construed as limiting the present invention. A high pass filter used as the basic filter may be frequency shifted to the low frequency side and a band pass filter used as the basic filter may be frequency shifted to the high frequency side and low frequency side.

By the way, the above-described embodiment is not more than a specific example in implementing the present invention and this should not be interpreted as restricting the technological scope of the present invention. That is, the invention may be embodied in other specific forms without departing from the spirit or essential characteristic thereof.

[Industrial Applicability]

The present invention is useful for designing an FIR digital filter as a type for comprising a tapped delay line which comprises a plurality of delay devices and for outputting the sum of results obtained by multiplying output signals of each tap several-fold by using each filter coefficient.

**Claims**

1. A method for designing a finite impulse response-type digital filter, comprising:

a first step of generating a plurality of frequency-shifted filters, through a frequency shift calculation to a basic filter which realizes frequency/amplitude characteristic having a passband width equal to a sampling frequency divided by an integer, which realizes the frequency/amplitude characteristics obtained from the frequency/amplitude characteristics of said basic filter being shifted by every prescribed frequency so that the adjacent filter banks are overlapped each other at the part of one-half amplitude; and

a second step of obtaining filter coefficients of the digital filter as a final product by summing the filter coefficients of one or more arbitrary filters extracted among a plurality of filters including said basic filter and said frequency-shifted filters.

2. A device for designing a finite impulse response-type digital filter, comprising:

a coefficient table storage means for storing a table data of filter coefficient group including filter coefficients of a basic filter which realizes frequency/amplitude characteristic having a passband width equal to a sampling frequency divided by an integer and filter coefficients of a plurality of frequency-shifted filters which realizes the frequency/amplitude characteristics obtained from the frequency/amplitude characteristics of said basic filter being shifted by every prescribed frequency so that the adjacent filter banks are overlapped each other at the part of one-half amplitude; and

a calculation means for obtaining filter coefficients of the digital filter as a final product by summing filter coefficients of one or more filters designated among the filter coefficient group stored in said coefficient table storage means.

# F I G. 1

```
        ┌──────────────────┐
        │      START       │
        └──────────────────┘
                 │
    ┌────────────────────────┐
    │  GENERATE BASIC FILTER  │        S1
    └────────────────────────┘
                 │
    ┌────────────────────────┐
    │       GENERATE          │        S2
    │ FREQUENCY-SHIFTED FILTER │
    └────────────────────────┘
                 │
    ┌────────────────────────┐
    │ SELECT DESIRED FILTERS AND │     S3
    │  ADD FILTER COEFFICIENTS   │
    │        THEREOF             │
    └────────────────────────┘
                 │
        ┌──────────────────┐
        │       END        │
        └──────────────────┘
```

# F I G. 2

```
        ┌──────────────────┐
        │      START       │
        └──────────────────┘
                 │
    ┌────────────────────────┐
    │     INSERT "0" TO        │        S11
    │   BASIC UNIT FILTER      │
    └────────────────────────┘
                 │
    ┌────────────────────────┐
    │ GENERATE WINDOW FILTER   │        S12
    │    USING INVERT FFT      │
    └────────────────────────┘
                 │
    ┌────────────────────────┐
    │ CASCADE CONNECT BASIC    │        S13
    │ UNIT FILTER AND WINDOW   │
    │        FILTER            │
    └────────────────────────┘
                 │
        ┌──────────────────┐
        │       END        │
        └──────────────────┘
```

F I G. 3

F I G. 4

F I G. 5

F I G.  6

F I G.  7

# F I G. 8

| L127 | WF | BASIC FILTER |
|---|---|---|
| 0 | | |
| 0 | | |
| 0 | $H_{-m}$ | $(-1) \times H_{-m}$ |
| 0 | $H_{-(m-1)}$ | $(-1) \times H_{-m} + 0 \times H_{-(m-1)}$ |
| -1 | | |
| 9 | | |
| 16 | $H_0$ | |
| 9 | | |
| -1 | $H_{m-1}$ | |
| 0 | $H_m$ | |
| 0 | | |
| 0 | | |
| 0 | | $(-1) \times H_m$ |

32

33

31

# F I G. 9

COEFFICIENT TABLE

| 0 | 1 | 2 | ------- |
|---|---|---|---|
| | | | |

11

CONTROLLER 12

OPERATION PART 13

DISPLAY PART 14

CALCULATION PART 15

## INTERNATIONAL SEARCH REPORT

| International application No. |
| --- |
| PCT/JP2004/010585 |

A. CLASSIFICATION OF SUBJECT MATTER
      Int.Cl⁷  H03H17/06

According to International Patent Classification (IPC) or to both national classification and IPC

B.  FIELDS SEARCHED

Minimum documentation searched (classification system followed by classification symbols)
      Int.Cl⁷  H03H17/00-17/08

Documentation searched other than minimum documentation to the extent that such documents are included in the fields searched
      Jitsuyo Shinan Koho        1922-1996    Toroku Jitsuyo Shinan Koho    1994-2004
      Kokai Jitsuyo Shinan Koho   1971-2004    Jitsuyo Shinan Toroku Koho    1996-2004

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| A | JP 62-82707 A  (Victor Company Of Japan, Ltd.), 16 April, 1987 (16.04.87), Page 2, upper left column, line 6 to page 3, upper right column, line 19; Figs. 3, 4 (Family: none) | 1,2 |
| A | JP 63-5607 A  (Fujitsu Ten Ltd.), 11 January, 1988 (11.01.88), page 2, upper left column, line 20 to lower left column, line 15; Figs. 1 to 3 (Family: none) | 1,2 |
| A | JP 7-135448 A  (Matsushita Electric Industrial Co., Ltd.), 23 May, 1995 (23.05.95), Par. Nos. [0008] to [0012]; Fig. 6 (Family: none) | 1,2 |

☐  Further documents are listed in the continuation of Box C.          ☐  See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 13 October, 2004 (13.10.04) | 26 October, 2004 (26.10.04) |

| Name and mailing address of the ISA/ | Authorized officer |
| --- | --- |
| Japanese Patent Office | |
| Facsimile No. | Telephone No. |

Form PCT/ISA/210 (second sheet) (January 2004)